**Europäisches Patentamt**

**European Patent Office**

**Office européen des brevets**

(19)

(11) Veröffentlichungsnummer: **0 196 495**
**B1**

(12) **EUROPÄISCHE PATENTSCHRIFT**

(45) Veröffentlichungstag der Patentschrift:
28.06.89

(21) Anmeldenummer: 86103013.8

(22) Anmeldetag: 06.03.86

(51) Int. Cl.⁴: **B 25 B  7/22**

(54) Zange.

(30) Priorität: 27.03.85 DE 3511086

(43) Veröffentlichungstag der Anmeldung:
08.10.86 Patentblatt 86/41

(45) Bekanntmachung des Hinweises auf die Patenterteilung: 28.06.89 Patentblatt 89/26

(84) Benannte Vertragsstaaten:
CH DE FR GB IT LI SE

(56) Entgegenhaltungen:
DE–A– 2 937 858
Katalog der Fa. Hoffmann GmbH & Co KG, Februar 1977, Seite 463 oben

(73) Patentinhaber: BELZER-DOWIDAT GMBH Werkzeug-Union
Hastener Strasse 4-8
D-5600 Wuppertal (DE)

(72) Erfinder: Bohl, Hans
Postfach 121
D-6407 Schlitz (DE)
Erfinder: Galle, Michael
Blumenstrasse 48
D-5630 Remscheid (DE)
Erfinder: Gutermuth, Rainer
Lupinenweg 13
D-6400 Fulda (DE)

(74) Vertreter: Selting, Günther, Dipl.-Ing. et al
Deichmannhaus am Hauptbahnhof
D-5000 Köln 1 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 196 495 B1

**Beschreibung**

Die Erfindung betrifft eine Zange mit zwei einander in einem Gelenk kreuzenden Zangenschenkeln, von denen jeder im vorderen Bereich als Arbeitsteil und im rückwärtigen Bereich als Griffteil ausgebildet ist, und mit einem die Schließbewegung begrenzenden Anschlag, wobei mindestens der eine Arbeitsteil ein Einstichorgan aufweist, das in bezug auf den Anschlag derart angeordnet ist, daß er sich im Schießzustand im Abstand vom gegenüberliegenden Arbeitsteil befindet.

Die üblichen Zangen dienen entweder zum Durchtrennen von Gegenständen, insbesondere Drähten, oder zum Festhalten von Gegenständen. Bekannt sind auch Elektrikerzangen, mit in Richtung der Arbeitsteile verlaufenden Schneiden zum Durchtrennen von Kabeln und halbkreisförmigen Schneiden zum Abisolieren, wobei der Isoliermantel eines Drahtes durchtrennt wird, während die Drahtseele im wesentlichen unversehrt bleibt. Von einem derartigen Stand der Technik, der z.B. aus dem Katalog 1977 der Firma Hoffmann GmbH & Co. KG, München, bekannt ist, geht der Oberbegriff des Patentanspruchs 1 aus.

Nachrichtenkabel, z. B. Telefonkabel, enthalten zahlreiche isolierte Adern. Eine Schwierigkeit bereitet bei großen Kabellängen das Überprüfen von Spleißstellen auf Durchgang und Nichtberührung bzw. Nichtkontakt zwischen den Leitern. Hierzu wird an eine der Adern an einem Kabelende eine elektrische Spannung gelegt und am anderen Kabelende werden die übrigen Adern daraufhin überprüft, ob an ihnen eine Spannung auftritt. Hierzu ist es erforderlich, die betreffende Kabelader an beiden Enden von ihrem Isolationsmantel zu befreien und an diesen Enden Prüfspitzen bzw. Prüfklemmen anzubringen. Nach Beendigung des Prüfvorganges werden die abisolierten Enden abgeschnitten.

Ähnliche Probleme treten auch bei Überprüfung und Lokalisierung von Kabelbeschädigungen an einem Kabel zwischen zwei Prüfstellen auf. In jedem Fall ist es erforderlich, zunächst die Isolierung von den Kabeladern zu befreien und dann Prüfklemmen anzubringen. Anschließend muß wieder eine entsprechende Isolierung angebracht werden, damit die Kabelseele nicht freiliegt.

Aus DE-A1-2 937 858 ist eine Anschlußklemme für Meßgeräte bekannt, die zwei durch ein Gelenk miteinander verbundene Zangenschenkel aufweist, deren Griffteile durch eine Feder auseinandergedrückt werden, um die Arbeitsteile gegeneinanderzudrücken. An einem der Arbeitsteile befindet sich eine Kontaktspitze, die unter dem Druck der Feder die Isolierung eines von der Anschlußklemme erfaßten Kabels durchsticht. Bei einer solchen Klemme handelt es sich nicht um eine Zange, die in der Form üblicher Zangen als Handwerkzeug benutzbar ist, um Gegenstände zu durchtrennen oder einzuspannen. Eine Zange hat zwei sich kreuzende Zangenschenkel, deren Arbeitsteile durch den Druck der Hand auf die Griffteile zusammengedrückt werden. Bei der bekannten Klemme ist eines der Klemmenbeine mit einer Anschlußvorrichtung zum bleibenden Anschluß eines Kabels versehen.

Der Erfindung liegt die Aufgabe zugrunde, eine in üblicher Weise als Handwerkzeug benutzbare Zange der eingangs genannten Art zu schaffen, die zusätzlich zum Prüfen von Kabeladern geeignet ist und den hierfür erforderlichen Arbeitsaufwand erheblich herabsetzt.

Die Lösung dieser Aufgabe besteht erfindungsgemäß darin, daß das Einstichorgan in Form einer in Längsrichtung des einen Arbeitsteils verlaufenden Schneide ausgebildet ist, und daß mindestens einer der Zangenschenkel eine als Steckverbinder ausgebildete elektrische Anschlußvorrichtung für ein Prüfkabel aufweist.

Die erfindungsgemäße Zange bildet eine « Adernprüfzange », die mit dem Einstichorgan den Adernmantel an einer sehr kleinen Stelle durchsticht, so daß das Einstichorgan in elektrisch leitenden Kontakt mit der Kabelseele kommt. Der elektrische Kontakt setzt sich über das leitende Material des Zangenschenkels bis zur Anschlußvorrichtung und von dieser zum Prüfkabel fort. Die Zange ermöglicht es somit, einen elektrischen Kontakt mit der Seele einer isolierten Ader herzustellen, ohne zuvor die Ader auftrennen und abisolieren zu müssen. Damit entfallen nicht nur die Vorgänge des Auftrennens und Abisolierens, sondern auch die bei der bekannten Vorgehensweise später erforderlichen Löt- und Spleißvorgänge. Durch den Freiraum zwischen den Zangenschenkeln im Kontaktbereich wird ein Durchtrennen der Adernseele verhindert. Bei der Anwendung wird der Druck auf die Adernprüfzange nur solange ausgeübt, bis der Kontakt zwischen dem Einstichorgan und der Adernseele hergestellt ist. Die Herstellung des Kontaktes wird durch Klingel- oder Leuchtzeichen bemerkt. Auf die Adernseele wird somit nur ein geringer Druck ausgeübt und die Adern-Ummantelung wird nur örtlich in ganz geringem Maße verletzt, ohne daß eine Entfernung von Isoliermaterial stattfinden würde. Der Isolationsgrad der Ader bleibt im wesentlichen erhalten.

Das Einstichorgan ist eine in Längsrichtung des einen Arbeitsteils verlaufende Schneide. Die Zange kann als Spitzzange ausgebildet sein, bei der die Arbeitsteile einen sich nach vorne verjüngenden Schnabel bilden. Dies ermöglicht es, mit der Zange auch an schwer zugänglichen und beengten Stellen die Adern zu sortieren bzw. eine bestimmte Ader aus dem Aderbündel zu vereinzeln und diese Ader zu prüfen, indem die betreffende Ader quer zwischen die Arbeitsteile der Zange eingeklemmt wird.

Vorzugsweise ist vorgesehen, daß der andere Arbeitsteil gegenüber dem Einstichorgan ein flaches geriffeltes Widerlager aufweist. In diesem Fall ist nur der Arbeitsteil des einen Zangenschenkels als Einstichorgan ausgebildet, während der andere das flache Widerlager bildet, gegen das die isolierte Ader gedrückt wird. Die Riffelung des flachen Widerlagers hat eine so geringe Tiefe, daß sie das Material der Adernisolierung nicht durchdringen oder beschädigen kann.

Das Einstichorgan kann sich in einem von dem Gelenk am weitesten entfernten Abschnitt des Arbeitsteils befinden, wobei ein weiterer Abschnitt vorgesehen ist, in dem die Arbeitsteile im Schließzustand flach gegeneinanderliegen. Eine derartige Zange kann zusätzlich als Flach- oder Haltezange benutzt werden, weil es möglich ist, mit dem weiteren Abschnitt Teile festzuhalten. Alternativ oder zusätzlich kann ein Zangenabschnitt mit im Schließzustand der Zange gegeneinanderstoßenden Schneiden vorgesehen sein, um Materialdurchtrennungen ausführen zu können.

Die Anschlußvorrichtung ist vorzugsweise an dem rückwärtigen Ende desjenigen Zangenschenkels angebracht, der das Einstichorgan aufweist, und sie bildet eine Verlängerung dieses Zangenschenkels. Die Anschlußvorrichtung behindert den Gebrauch der Zange nicht und vermindert auch nicht deren mechanische Stabilität.

Die Anschlußvorrichtung ist eine mit dem betreffenden Zangenschenkel elektrisch verbundene, von Isoliermaterial umgebene Anschlußbuchse. Die elektrische Leitfähigkeit des Zangenschenkels wird für den Prüfvorgang ausgenutzt. Die Anschlußbuchse ist elektrisch mit demjenigen Zangenschenkel verbunden, der mit der Kabelader in direkten Kontakt kommt. Auf diese Weise werden unsichere Übergangswiderstände im Bereich des Zangengelenks vermieden.

Gemäß einer bevorzugten Ausführungsform der Erfindung ist das die Anschlußbuchse umgebende Isoliermaterial einer isolierenden Ummantelung des Griffteils dieses Zangenschenkels einstückig angeformt und es steht über die Ummantelung des anderen Zangenschenkels nach hinten ab. Eine derartige Zange ist einfach und kostengünstig zu fertigen, ihr Gebrauch wird durch die Anschlußvorrichtung praktisch nicht behindert, und es wird ein sicherer und störungsfreier Kontakt mit dem Prüfkabel gewährleistet.

Im folgenden wird ein Ausführungsbeispiel der Erfindung unter Bezugnahme auf die Zeichnungen näher erläutert.

Es zeigen :

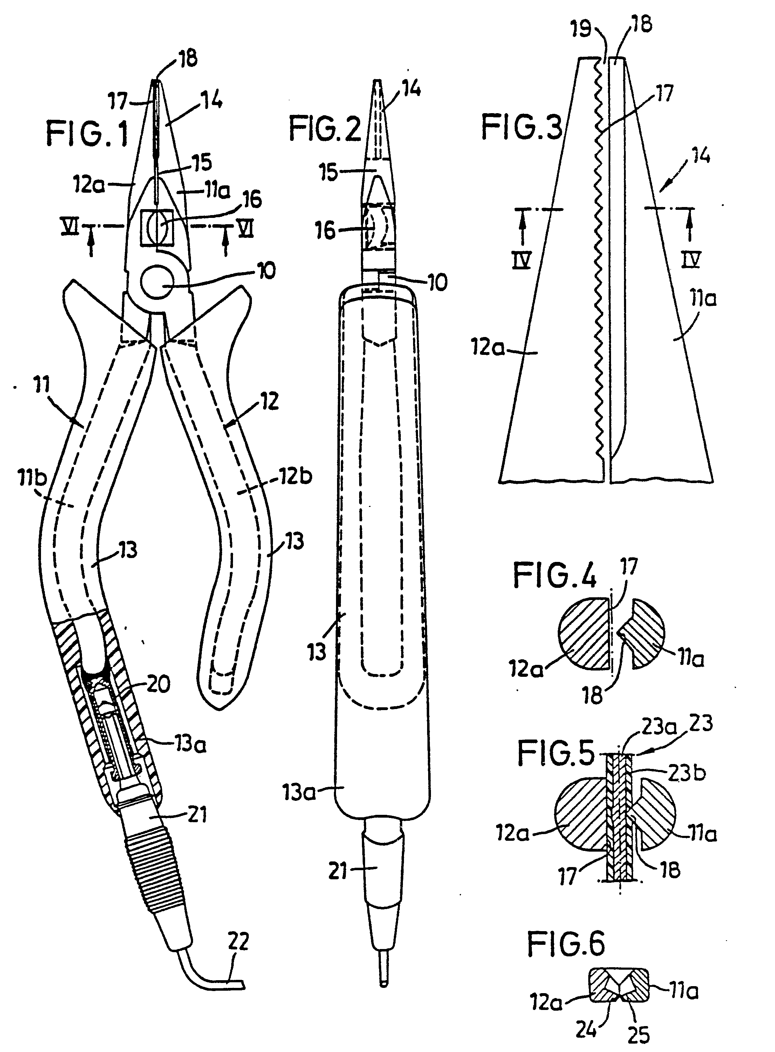

Fig. 1 eine Seitenansicht der Adernprüfzange, Fig. 2 eine Stirnansicht der Adernprüfzange, Fig. 3 in vergrößertem Maßstab eine Darstellung der vorderen Enden der Zangenschenkel im Schließzustand, Fig. 4 einen Schnitt entlang der Linie IV-IV von Fig. 3, Fig. 5 in gleicher Darstellung wie Fig. 4 den Zustand der Arbeitsteile beim Durchstechen des Isoliermantels einer Kabelader und Fig. 6 einen Schnitt entlang der Linie VI-VI von Fig. 1.

Die dargestellte Adernprüfzange weist die beiden einander in dem Gelenk 10 kreuzenden Zangenschenkel 11 und 12 auf. Die Zangenschenkel bestehen jeweils aus dem vorderen Arbeitsteil 11a bzw. 12a und dem rückwärtigen Griffteil 11b bzw. 12b. Die Griffteile 11b,12b sind jeweils mit einer ergonomisch geformten isolierenden Ummantelung 13 aus Kunststoff umhüllt.

Die Arbeitsteile sind unterteilt in einen vorderen Prüfabschnitt 14, einen mittleren Halteabschnitt 15 und einen dem Gelenk 10 zugewandten Trennabschnitt 16. Der Prüfabschnitt 14 ist in Fig. 3 dargestellt. Der Arbeitsteil 12a ist an seiner dem Arbeitsteil 11a zugewandten Seite als flaches geriffeltes Widerlager 17 ausgebildet. An der dem Widerlager 17 gegenüberliegenden Seite weist der Arbeitsteil 11a ein Einstichorgan 18 in Form einer längslaufenden Schneide auf. Die Spitze dieser Schneide ist in Richtung auf das Widerlager 17 gerichtet und verläuft durch die Längsmittelebene der Arbeitsteile 11a und 12a. Das Einstichorgan 18 ist symmetrisch zu dieser Längsmittelebene ausgebildet und bildet im Querschnitt einen spitzen Winkel.

Die Schließbewegung der Zangenschenkel 11 und 12 wird dadurch begrenzt, daß die Zangenschenkel im Klemmbereich 15 bzw. im Schneidbereich 16 gegeneinanderstoßen. In diesem Zustand befindet sich zwischen der Spitze des Einstichorgans 18 und dem gegenüberliegenden Widerlager 17 ein Freiraum 19. Die Weite dieses Freiraums ist an dem vorderen Zangenende am größten und verringert sich zum rückwärtigen Ende des Prüfabschnitts 14 hin.

Die Zangenschenkel 11 und 12 bestehen aus Stahl und sind somit leitend. An das Griffteil 11b ist die Anschlußvorrichtung 20 angebracht. Dieses besteht aus einer im wesentlichen zylindrischen Steckbuchse, welche den Griffteil 11b nach hinten verlängert. Entsprechend ist der Isoliermantel 13 des Griffteils 11b mit einer Verlängerung 13a versehen, die die Anschlußvorrichtung 20 seitlich umschließt und nach hinten über die Anschlußvorrichtung übersteht. In die Anschlußvorrichtung 20 wird der Kontakt eines einpoligen Steckers 21 eingesteckt, der mit dem Prüfkabel 22 verbunden ist. Das Griffteil des Steckers 21 ragt in Längsrichtung aus dem Ende des Ansatzes 13a heraus und die Öffnung am Ende des Ansatzes 13a umschließt den Handgriff des Steckers 21 dicht, so daß nicht nur der Kontaktbereich von dem Ansatz 13a umschlossen ist, sondern auch der vordere Bereich des Handgriffs des Steckers 21.

Bei Benutzung der Adernprüfzange wird der Prüfabschnitt 14a gemäß Fig. 5 an eine Ader 23 angesetzt. Dabei stützt sich der Isoliermantel 23b an dem Widerlager 17ab. Beim Zusammendrücken der Zangenschenkel 11 und 12 dringt das Einstichorgan 18 des Arbeitsteils 11a von einer Seite her durch den Isoliermantel 23b hindurch, so daß seine Spitze in Kontakt mit der Adernseele 23a kommt. Dadurch wird ein elektrischer Kontakt zwischen der Kabelseele 23a und dem Prüfkabel 22 über den Zangenschenkel 11 hergestellt. Werden danach die Zangenschenkel wieder auseinanderbewegt, dann schließt sich der schmale Spalt, den das Einstichorgan 18 im Adernmantel 23b erzeugt hat, infolge der Rückstellfähigkeit des Kunststoffmaterials, aus dem der Adernmantel besteht, teilweise selbst wieder.

Im Trennbereich 16 weist die Zange gemäß Fig.

6 zwei Schneiden 24, 25 auf, die bei gegeneinandergedrückten Zangenschenkeln einander berühren. Auf diese Weise kann die Zange auch zum Durchkneifen von Drähten bzw. Adern benutzt werden.

**Patentansprüche**

1. Zange mit zwei einander in einem Gelenk (10) kreuzenden Zangenschenkeln (11, 12), von denen jeder im vorderen Bereich als Arbeitsteil (11a, 12a) und im rückwärtigen Bereich als Griffteil (11b, 12b) ausgebildet ist, und mit einem die Schließbewegung begrenzenden Anschlag, wobei mindestens der eine Arbeitsteil (11a) ein Einstichorgan (18) aufweist, das in bezug auf den Anschlag derart angeordnet ist, daß es sich im Schließzustand im Abstand von dem gegenüberliegenden Arbeitsteil (12a) befindet, dadurch gekennzeichnet, daß das Einstichorgan (18) in Form einer in Längsrichtung des einen Arbeitsteils (11a) verlaufenden Schneide ausgebildet ist und daß mindestens einer der Zangenschenkel (11, 12) eine als Steckverbinder ausgebildete elektrische Anschlußvorrichtung (20) für ein Prüfkabel (22) aufweist.

2. Zange nach Anspruch 1, dadurch gekennzeichnet, daß der andere Arbeitsteil (12a) ein flaches geriffeltes Widerlager (17) aufweist.

3. Zange nach Anspruch 1 oder 2, dadurch gekennzeichnet, daß sich das Einstichorgan (18) in einem von dem Gelenk (10) am weitesten entfernten Abschnitt (14) des Arbeitsteils (11a) befindet und daß ein weiterer Abschnitt (15) vorgesehen ist, in dem die Arbeitsteile (11a, 12a) im Schließzustand flach gegeneinanderliegen.

4. Zange nach einem der Ansprüche 1 bis 3, dadurch gekennzeichnet, daß die Anschlußvorrichtung (20) an dem rückwärtigen Ende desjenigen Zangenschenkels (11) angebracht ist, der das Einstichorgan (18) aufweist, und eine Verlängerung dieses Zangenschenkels (11) bildet.

5. Zange nach einem der Ansprüche 1 bis 4, dadurch gekennzeichnet, daß die Anschlußvorrichtung (20) eine mit dem betreffenden Zangenschenkel (11) elektrisch verbundene, von Isoliermaterial (13a) umgebene Anschlußbuchse ist.

6. Zange nach Anspruch 5, dadurch gekennzeichnet, daß das die Anschlußbuchse umgebende Isoliermaterial (13a) einer isolierenden Ummantelung (13) des Griffteils (11b) dieses Zangenschenkels (11) einstückig angeformt ist und über die Ummantelung des anderen Zangenschenkels (12) hinaus nach hinten absteht.

**Claims**

1. A pair of pliers having two plier legs (11, 12) crossing each other in a joint (10), the front portion of each of said plier legs being designed as a working part (11a, 12a) and its rear portion being designed as a handle part (11b, 12b), said pair of pliers having a stop member limiting the closing movement, at least the one working part (11a) being provided with an insertion member (18) arranged relative to said stop member such that said insertion member (10) is spaced from the opposite working part (12a) in the closed state, characterised in that said insertion member (18) is provided in the form of a blade extending in the lengthwise direction of the said one working part (11a), and that at least one of said plier legs (11, 12) is provided with an electric connection means (20) designed as a plug connector for a measuring cable (22).

2. The pair of pliers according to Claim 1, characterised in that the other working part (12a) is provided with a flat, rifled abutment (17).

3. The pair of pliers according to Claim 1 or 2, characterised in that said insertion member (18) is arranged in a portion (14) of the working part (11a) that is most distant from said joint (10) and that a further portion (15) is provided in which said working parts (11a, 12a) are in flat contact in the closed state.

4. The pair of pliers according to one of Claims 1 to 3, characterised in that said connection means (20) is arranged at the rear end of that plier leg (11) that is provided with said insertion member (18), and forms an extension of said plier leg (11).

5. The pair of pliers according to one of Claims 1 to 4, characterised in that said connection means (20) is a connecting socket electrically connected to said respective plier leg (11) and surrounded by insulating material (13a).

6. The pair of pliers according to Claim 5, characterised in that the insulating material (13a) surrounding said connecting socket is integrally formed with an insulating sheath (13) of the handle part (11b) of the respective plier leg (11) and protrudes rearward beyond the sheath of the other plier leg (12).

**Revendications**

1. Pince comportant deux branches (11, 12) qui se croisent suivant une articulation (10) et dont chacune est réalisée dans sa partie avant sous la forme d'une partie travaillante (11a, 12a) et dans sa partie arrière sous la forme d'une poignée (11b, 12b), et comportant une butée limitant le mouvement de fermeture, au moins l'une (11a) des parties travaillantes comportant un organe à entailler (18) qui est disposé par rapport à la butée de façon telle qu'à l'état fermé, il se trouve à une certaine distance de la partie travaillante (12a) opposée, caractérisée en ce que l'organe à entailler (18) est réalisé sous la forme d'un tranchant s'étendant suivant la direction longitudinale de la première partie travaillante (11a) et en ce qu'au moins l'une des branches (11, 12) de la pince comporte un dispositif de connexion électrique (20), réalisé sous la forme d'un connecteur à fiche, pour un câble de contrôle (22).

2. Pince suivant la revendication 1, caractérisée en ce que l'autre partie travaillante (12a) comporte un appui cranté plat (17).

3. Pince suivant la revendication 1 ou 2, caractérisée en ce que l'organe à entailler (18) se trouve situé sur un tronçon (14) de la partie travaillante (11a) qui est le plus éloigné de l'articulation (10) et en ce qu'il est prévu un autre tronçon (15) où, à l'état fermé, les parties travaillantes (11a, 12a) s'appliquent à plat l'une sur l'autre.

4. Pince suivant l'une des revendications 1 à 3, caractérisée en ce que le dispositif de connexion (20) est monté à l'extrémité arrière de la branche (11) de la pince comportant l'organe à entailler (18) et constitue un prolongement de cette branche (11) de la pince.

5. Pince suivant l'une des revendications 1 à 4, caractérisée en ce que le dispositif de connexion (20) est une douille de connexion reliée électriquement à la branche concernée (11) de la pince et entourée de matière isolante (13a).

6. Pince suivant la revendication 5, caractérisée en ce que la matière isolante (13a) entourant la douille de connexion est réalisée en une seule pièce avec un gaînage isolant (13) de la poignée (11b) de ladite branche (11) de la pince et fait saillie vers l'arrière au-delà du gaînage de l'autre branche (12) de la pince.

FIG.1

FIG.2

FIG.3

FIG.4

FIG.5

FIG.6